Europäisches Patentamt

European Patent Office

Office européen des brevets

(11) Publication number: **0 058 064**
**B1**

# EUROPEAN PATENT SPECIFICATION

(45) Date of publication of patent specification: **02.12.87**

(21) Application number: **82300587.1**

(22) Date of filing: **05.02.82**

(51) Int. Cl.⁴: **H 03 M 1/82**

(54) **Digital-to-analog conversion apparatus.**

(30) Priority: **05.02.81 JP 16517/81**

(43) Date of publication of application:
**18.08.82 Bulletin 82/33**

(45) Publication of the grant of the patent:
**02.12.87 Bulletin 87/49**

(84) Designated Contracting States:
**DE FR GB**

(56) References cited:
**FR-A-2 398 415**
**GB-A-2 000 653**
**US-A-4 126 853**

**IEEE TRANSACTIONS ON CONSUMER
ELECTRONICS, vol. CE-25, August 1979, page
432, IEEE, New York, US; M.TAMURA et al.:
"Digital signal processing LSI for home VTR
servo circuit"**

(73) Proprietor: **Matsushita Electric Industrial Co.,
Ltd.
1006, Oaza Kadoma
Kadoma-shi Osaka-fu, 571 (JP)**

(72) Inventor: **Minakuchi, Hiroshi
807, Nishiyurugi Adagawa-cho
Takashima-gun Shiga-ken (JP)**

(74) Representative: **Crawford, Andrew Birkby et al
A.A. THORNTON & CO. Northumberland House
303-306 High Holborn
London WC1V 7LE (GB)**

Courier Press, Leamington Spa, England.

## Description

This invention relates to a digital-to-analog conversion apparatus which is so constructed that the active level duration of output signal during a reference period changes corresponding to a digital input value.

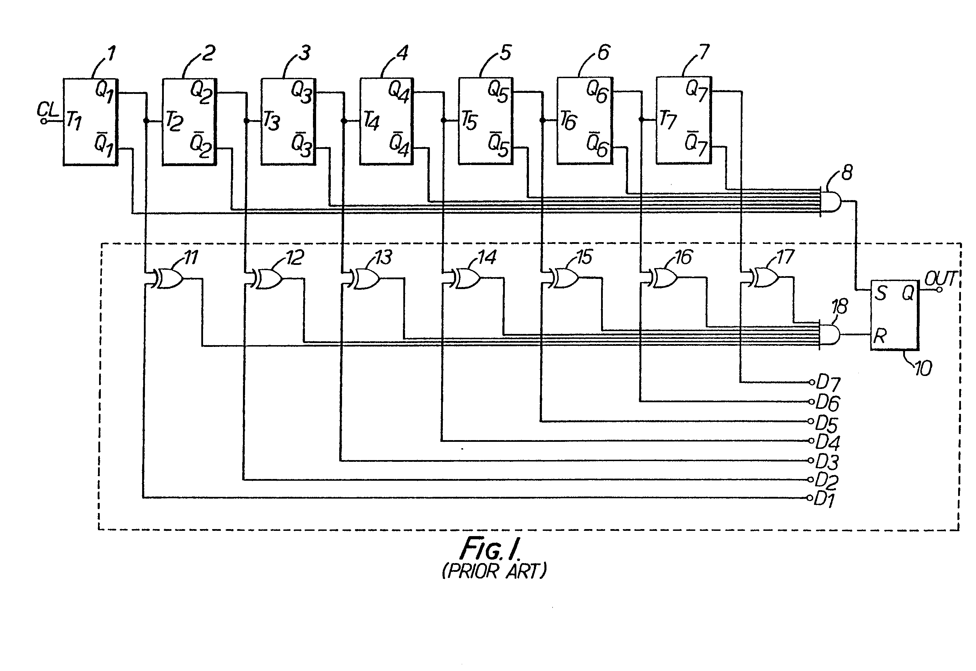

Conventionally, this kind of digital-to-analog converter has been usually employed as is disclosed in "Digital Signal Processing LSI for Home VTR Servo Circuit", IEEE Transactions on Consumer Electronics, Vol. CE-25, pages 429—438 by Tamura et al., and a normalized logical diagram is shown in Fig. 1.

In Fig. 1, T flip-flops 1, 2, 3, 4, 5, 6 and 7 constitute a 7-bit down-counter, inverted output terminals $\bar{Q}1$ to $\bar{Q}7$ of the respective T flip-flops 1 to 7 are connected to input terminals of an AND gate 8 for detecting an end of down-counting, and an output terminal of AND gate 8 is connected to a set terminal of a RS flip-flop 10.

While, between the non-inverted output terminals Q1 to Q7 and digital input terminals D1 to D7 are interposed EX-OR gates 11, 12, 13, 14, 15, 16 and 17, and output terminals thereof are connected to input terminals of an AND gate 18 for coincident detection respectively. An output terminal of AND gate 18 is connected to a reset terminal of RS flip-flop 10, thereby applying an output thereof to an output terminal OUT. Also, clock terminal T1 is connected to a clock pulse input terminal CL.

Now, EX-OR gates 11 to 17 and AND gate 18 in Fig. 1, constitute digital comparator disclosed in the aforesaid IEEE Paper, which generates a reset signal for RS flip-flop 10 when a digital input value appears on digital input terminals D1 to D7 coincides with an inverted counting value of the 7-bit down-counter. AND gate 8 generates a set signal for RS flip-flop 10 at the end of counting of the down-counter.

For example, when digital input value [1001110] is given, an output level of the terminal OUT turns to "0" when the output of the down-counter becomes [0110001], and returns to "1" when the output becomes [0000000], and thereafter the same operation will repeat so on.

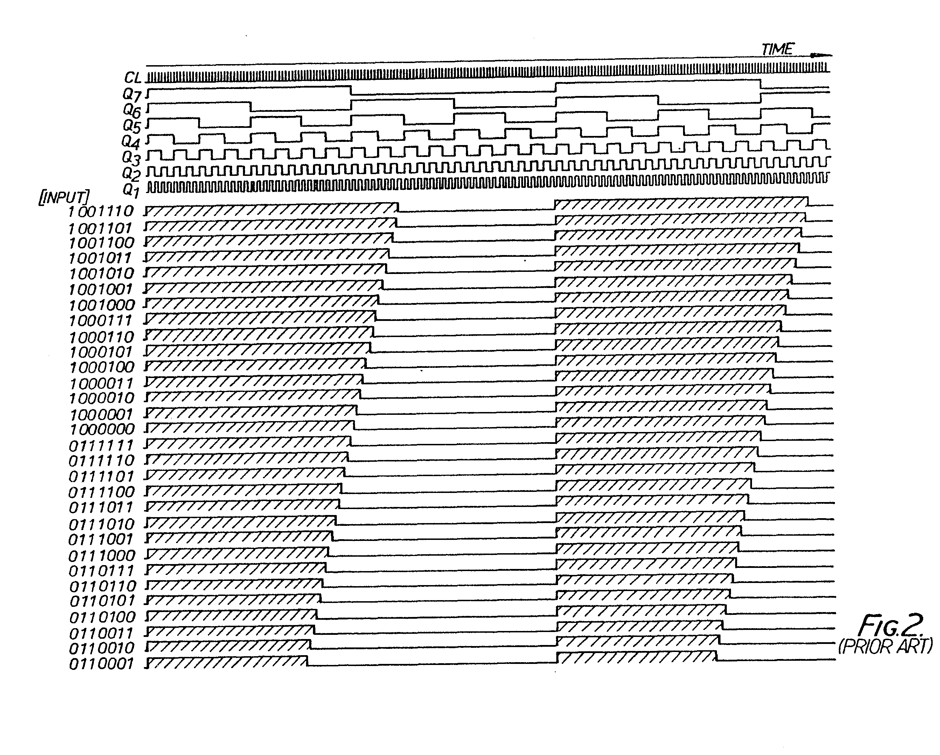

If the active level is chosen to be "1", the active-level duration during a reference period of the output signal on the terminal OUT (in Fig. 1, the reference period corresponds to the count-end period of the down-counter) varies as shown in Fig. 2, corresponding to a change of the digital input values, the active-level duration being shown by hatching Fig. 2.

In addition, in Fig. 2, reference CL designates a clock pulse signal waveform, and Q7, Q6, Q5, Q4, Q3, Q2 and Q1 designate output signal waveforms of T flip-flops 7, 6, 5, 4, 3, 2 and 1 in Fig. 1 respectively.

Thus, the analog voltage corresponding to the digital input value is obtained from a low-pass filter or the like which is supplied the output signal on the terminal OUT. Or, in a case of driving a light-emitting diode or a filament lamp, the reference period, when increased to an extent of not sensing the flickering, can change the intensity of illumination, even without using the low-pass filter or the like, corresponding to the digital input value.

The digital-to-analog convertor shown in Fig. 1 also cannot be expected of its desired function because of generation of a hazard (glitch) in its circuit as original. In other words, a signal transfer delay occurs inevitably between the input and the output of each flip-flop in Fig. 1 to result in that the coincident detection by AND gate 18, during the transition of output of each flip-flop, will generate an erroneous output.

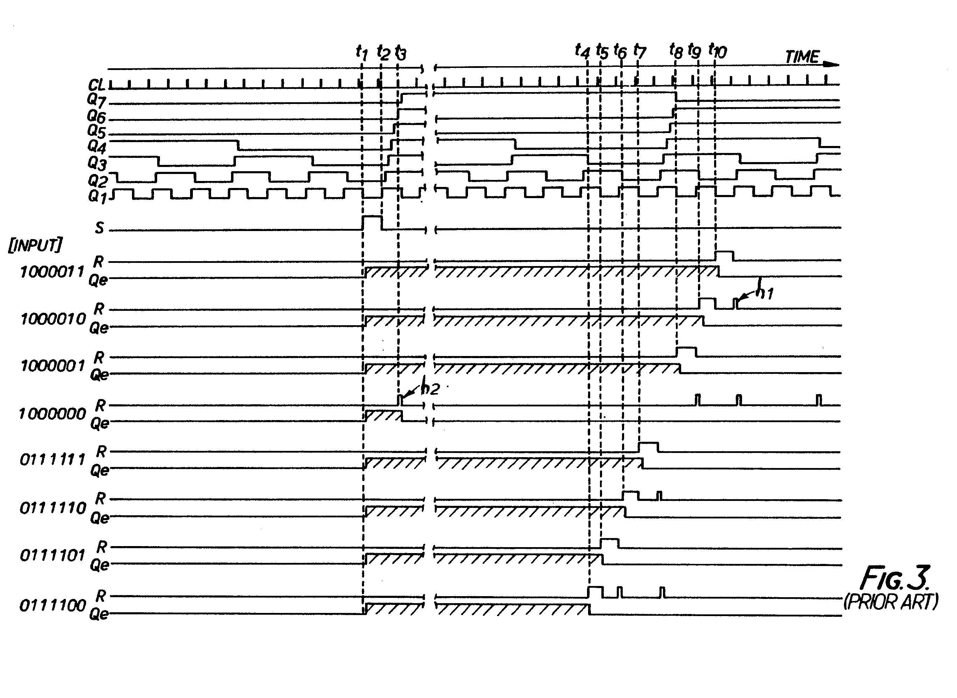

Fig. 3 is a timing chart for explanation of the above, which is the same in a main point as that in Fig. 2, but is enlarged of the axis of time in comparison with Fig. 2, and the transfer delay having a time equal to 1/6 of the clock pulse period occurs in each flip-flop, but AND gates 8 and 18 and EX-OR gates 11 to 17, for the convenience, are negligible of the transfer delay.

At a time $t_1$, an output of the down-counter becomes [0000000] and AND gate 8 generates a set signal for RS flip-flop 10 as shown by the signal waveform S in Fig. 3.

If we assume that [1000011] is applied as the digital input value, the output of the down-counter becomes [0111100] at a time $t_{10}$, whereby AND gate 18 generates a reset signal for RS flip-flop 10.

Hence, the level change of an output terminal $Q_e$ of RS flip-flop 10 delays by 1/6 of one clock period from the time $t_1$ and turns to "1", then delays by 1/6 of one clock period from the time $t_{10}$ and turns to "0".

Similarly, when [1000010] is applied as the digital input value, the level of output terminal $Q_e$ at RS flip-flop 10 turns to "1" after a delay from the time $t_1$ by 1/6 of one clock period, and turns to "0" after the delay from $t_8$.

Furthermore, when [1000001] is applied as the digital input value, the level of output terminal $Q_e$ at RS flip-flop 10 turns to "1" after delay from the time $t_1$, then after turns to "0" by the delay from the time $t_8$.

In Fig. 3, the output signal active-level durations at the digital input value [1000011], [1000010] and [1000001], in comparison with each other, are found not to exactly correspond to a change of the digital input values.

In other words, the active level duration due to decrease by every one clock period, but only by 5/6 clock period between the digital input values [1000011] and [1000010] and by 7/6 clock period between the digital input values [1000010] and [1000001], in which an error of 1/6 clock period is created in both cases. In brief, the digital-to-analog converter in Fig. 1 makes a transfer error corresponding to a delay time for signal transfer at the T flip-flop constituting the down-counter.

When a digital input value [1000010] is applied, although a hazard $h_1$ is generated at the time $t_{10}$ after the level of reset terminal of RS flip-flop 10 returns to "0", at which time RS flip-flop 10 has already been reset not to affect the whole operation.

However, the hazard, when [1000000] is applied as the digital input value, leads to a malfunction in the apparatus. Since the output of the down-counter instantaneously becomes [0111111] at the time $t_3$, a hazard $h_2$ is applied to a reset terminal R of RS flip-flop 10, in the result the output level of the RS flip-flop turns to "0" and its output signal far different from the original waveform.

In a case that [0111111], [0111101] or [0111100] is applied as the digital input value, an influence of a hazard can again be avoided, but an error from the signal transfer delay is still made.

In order to avoid the above problems, the counter comprising T flip-flops 1 to 7 is made of synchronous type and of a high speed type and a hazard appearance region is kept within at least 1/2 clock period from the leading edge of the clock pulse, and thereafter the synchronized output of the digital comparator is picked up at the trailing edge of the clock pulse.

These countermeasures, however, are defective in an increase in the number of gates or an increased consumption power.

In addition, the portions surrounded by the broken line in Fig. 1, for example in a servo system of a video tape recorder disclosed in the aforesaid paper IEEE, will require four channels for speed control and phase control for a capstan motor and those for a cylinder motor, but the portion must be employed all high-speed gates for preventing malfunction. Especially, when the whole system is intended to be one-chip IC, many problems have occurred by increased consumption power and increased chip size.

FR—A—2398415 discloses a digital-to-analog conversion apparatus comprising: a binary counter having a clock pulse input terminal connected to a clock pulse source; a decoding gate means having a plurality of input terminals coupled to each of output bits of said binary counter and generating output signals of binary-weighted pulse widths respectively; a plurality of digital input terminals for receiving a digital input value; a plurality of first logical gates which are respectively connected at their respective first input terminals to output terminals of said decoding gate means and at their respective second input terminals to said digital input terminals; a second logical gate coupled at its input terminals to output terminals of said first logical gates; and an output means for generating an output signal the number of changes and active-level duration of said output signal varying depending on said digital input value.

The problem with such an arrangement is the same as that discussed with reference to Figs. 1 to 3, namely errors from signal transfer delay.

It is an object of the invention to avoid the problem discussed above.

The present invention therefore provides a digital-to-analog conversion apparatus of the type mentioned above, wherein said output means comprises: a logical NAND gate having first and second input terminals respectively coupled to the MSB (most significant bit) of said binary counter and the MSB of said digital input terminals; a logical NOR gate having first and second input terminals respectively coupled to the MSB of said binary counter and the MSB of said digital input terminals; a logical OR gate having a first and second input terminals respectively coupled to an output terminal of said logical NOR gate and an output terminal of said second logical gate; and a logical AND gate having first and second input terminals coupled to an output terminal of said logical NAND gate and an output terminal of said logical OR gate.

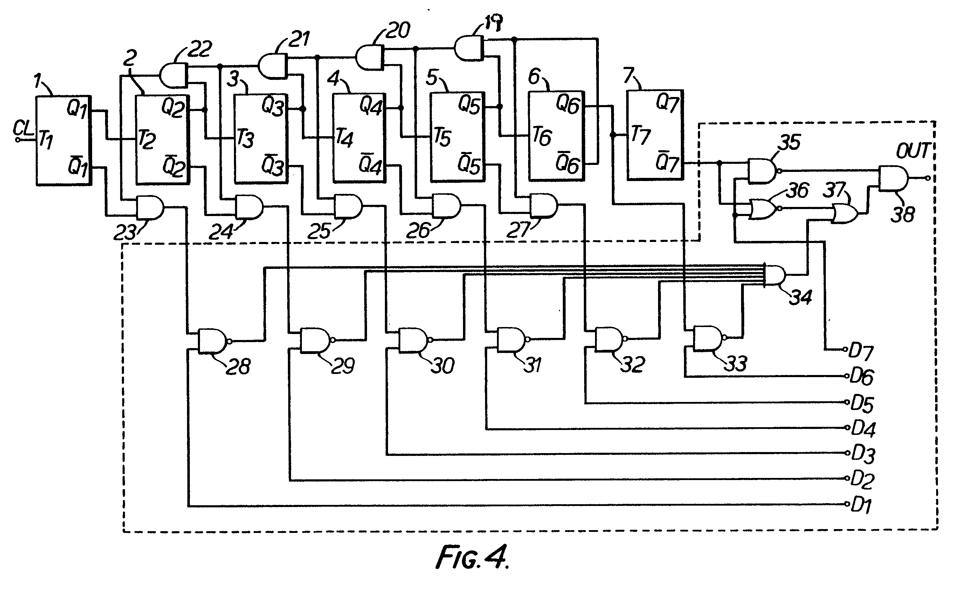

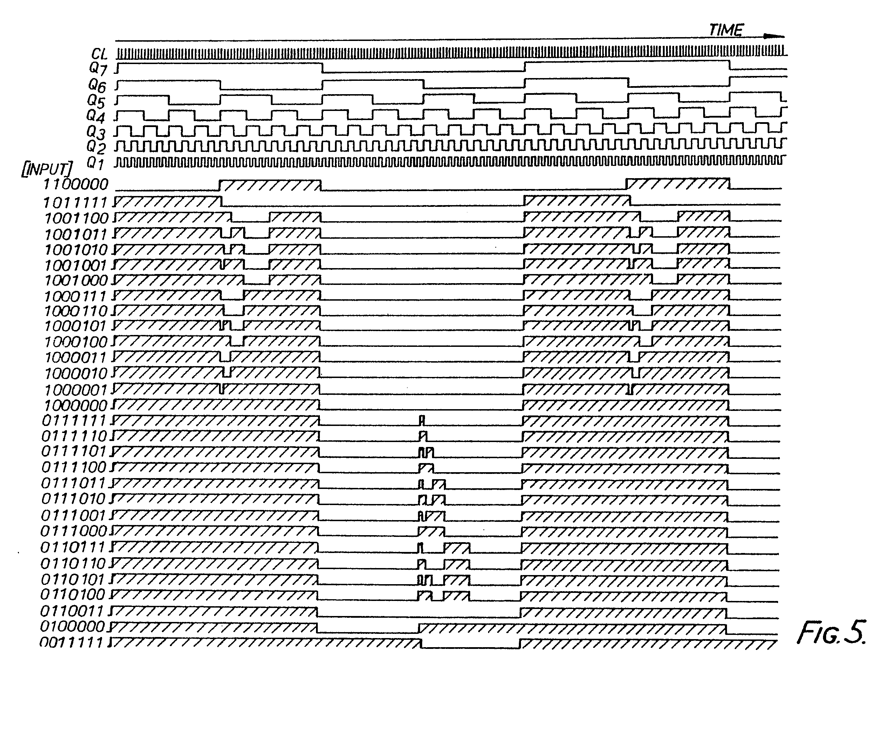

Figure 1 is a logic diagram of an exemplary construction of a conventional digital-to-analog converter, Figs. 2 and 3 are timing charts explanatory of operation of the Fig. 1 converter, Fig. 4 is a logic diagram of an embodiment of a digital-to-analog conversion apparatus of the invention, and Figs. 5 through 7 are timing charts explanatory of operation of the Fig. 4 embodiment.

Detailed description of the invention

Fig. 4 is a logic diagram of an embodiment of a digital-to-analog conversion apparatus of the invention, in which T flip-flops 1 to 7, as the same as Fig. 1, constitute 7-bit down counter, an inverted output terminal $\bar{Q}6$ of T flip-flop 6 and a non-inverted output termianl Q5 of T flip-flop 5 being connected to input terminals of an AND gate 19, an output terminal thereof and a non-inverted output terminal Q4 of T flip-flop 4 being connected to input terminals of an AND gate 20, an output terminal thereof and a non-inverted output terminal Q3 of T flip-flop 3 being connected to input terminals of an AND gate 21, and an output terminal thereof and a non-inverted output terminal Q2 of T flip-flop 2 being connected to input terminals of AND gate 22. An output terminal of AND gate 22 and an inverted output terminal $\bar{Q}1$ of T flip-flop 1 are connected to input terminals of an AND gate 23, an output terminal of AND gate 21 and an inverted output terminal $\bar{Q}2$ of T flip-flop 2 being connected to input terminals of an AND gate 24, an output terminal of AND gate 20 and an inverted output terminal $\bar{Q}3$ of T flip-flop 3 being connected to input terminals of an AND gate 25, an output terminal of AND gate 19 and an inverted output terminal $\bar{Q}4$ of T flip-flop 4 being connected to input terminals of an AND gate 26, and an inverted output terminal $\bar{Q}6$ of T flip-flop 6 and an inverted output terminal $\bar{Q}5$ of T flip-flop 5 being connected to input terminals of an AND gate 27.

Furthermore, an output terminal of AND gate 23 and a digital input terminal $D_1$ are connected to input terminals of a NAND gate 28, an output terminal of AND gate 24 and a digital input terminal $D_2$ being connected to input terminals of a NAND gate 29, an output terminal of AND gate 25 and a digital input terminal $D_3$ being connected to input terminals of a NAND gate 30, an output terminal of AND gate 26 and a digital input terminal $D_4$ being connected to input terminals of a NAND gate 31, an output terminal of AND gate 27 and a digital input terminal $D_5$ being connected to input terminals of a NAND gate 32, a non-inverted output terminal Q6 and a digital input terminal $D_6$ being connected to input terminals of a NAND gate 33, and output terminals of NAND gates 28 to 33 being connected to input terminals of an AND gate 34 respectively.

On the other hand, an inverted output terminal $\overline{Q}7$ of T flip-flop 7 and a digital input terminal $D_7$ are connected to input terminals of a NAND gate 35 and a NOR gate 36 respectively, an output terminal of NOR gate 36 and an output terminal of AND gate 34 being connected to input terminals of an OR gate 37, an output terminal of NAND gate 35 and an output terminal of OR gate 37 being connected to input terminals of an AND gate 38, and an output terminal of AND gate 38 being connected to a signal output terminal OUT.

Referring to Fig. 4, AND gate 23 constitutes a first decoding gate which generates an output signal when the 7-bit down-counter comprising T flip-flops 1 to 7 outputs [x011110] (x designates irrelative level). Also, AND gate 24 constitutes a second decoding gate which generates an output signal when the down-counter outputs [x01110x]; AND gate 25, a third decoding gate generating an output signal when the output of the down-counter becomes [x0110xx]; AND gate 26, a fourth decoding gate generating an output signal when the output of the down-counter becomes [x010xxx]; the AND gate 27, a fifth decoding gate generating an output signal when the output of the counter becomes [x00xxxx]; and AND gates 19, 20, 21 and 22 constitute auxiliary gates for decoding gates 23 to 27 respectively.

The first decoding gate 23 twice generates the output signals when the down-counter outputs [1011110] and [0011110], one output duration being equal to a clock pulse period. The second decoding gate 24 twice generates the output signals when the output of down-counter is given between [1011101] and [1011100] and between [0011101] and [0011100], one output duration being equal to two times the clock pulse period. The third decoding gate 25 generates the output signals twice when the output of the down-counter is given between [1011011] and [1011000] and between [0011011] and [0011000], one output duration being equal to four times the clock pulse period. The fourth decoding gate 26 generates the output signals twice when the output of the down-counter is given between [1010111] and [1010000] and between [0010111] and [0010000], one output duration being equal to eight times the clock pulse period. The fifth decoding gate 27 generates the output signals twice when the output of the down-counter is given between [1001111] and [1000000] and betweeen [0001111] and [0000000], one output duration being equal to sixteen times the clock pulse period.

In other words, the second decoding gate 24 is binary-weighted for its output duration with respect to the first decoding gate 23, and similarly, the third, fourth, and fifth decoding gates 25, 26 and 27 are binary weighted for output durations thereof with respect to the second, third and fourth decoding gates 24, 25 and 26 respectively.

NAND gates 28, 29, 30, 31, 32 and 33 constitute logical AND gates generating output signals when levels of both input terminals of the NAND gates turn to "1", AND gate 34 constituting a negative logical OR gate, which generates an output signal when the level of either one input terminal of the AND gate 24 turns to "0".

While, NAND gate 35, NOR gate 36, OR gate 37 and AND gate 38 constitute a selection gate which decides an effective active region of AND gate 34 corresponding to a level of MSB (most significant bit) in the digital input value.

Under the level of MSB $D_7$ is "1", the output level of NOR gate 36 is fixed principally to "0", and when the level of MSB (Q7) at the 7-bit down-counter is "0", the output level of NAND gate 35 turns to "0" and the level of the output terminal out also turns to "0", or when the level of MSB at the 7-bit down-counter is "1", the output level of NAND gate 35 is fixed principally to "1", whereby the output level of the AND gate 34 appears directly on the output terminal OUT.

On the other hand, when the level of MSB $D_7$ is "0", the output level of NAND gate 35 is fixed principally to "1" and output level of OR gate 37 appears directly on the output terminal OUT. In other words, under the level of MSB at the 7-bit down-counter is "1", the output level of NOR gate 36 turns to "1", whereby the level of the output terminal OUT turns to "1" regardless of an output condition of AND gate 34. When the level of MSB at the 7-bit down-counter is "0", the output level of NOR gate 36 turns to "0", whereby the output level of AND gate 34 appears directly on the output terminal OUT.

Finally, the active level duration of the output signal, when the digital input values are changed in variety, changes as shown in Fig. 5, and that during the reference period changes corresponding to a change of the digital input values.

As seen from Fig. 5, while the apparatus in Fig. 1 performs the digital-to-analog conversion by PWM (pulse width modulation), the embodiment of the invention in Fig. 4 performs the same by BPM (bit pattern modulation).

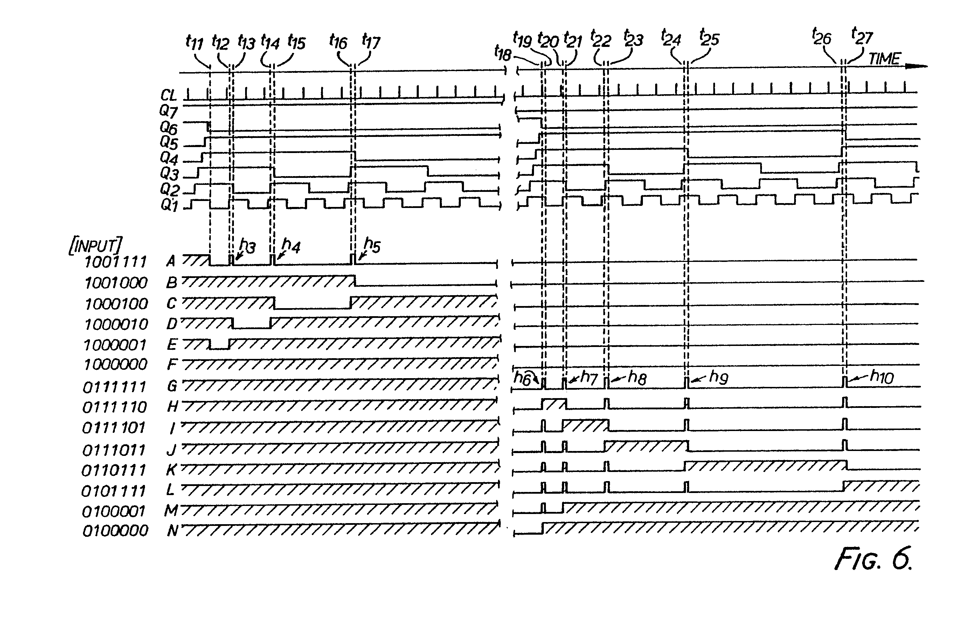

Fig. 6, as the same as Fig. 3, shows the output signal waveforms for varying the digital input values, assuming that in each flip-flop a transfer delay having a time equel to 1/6 of the clock pulse period will occur.

The output waveform, when [1001111] is applied as the digital input value, is affected by the transfer delay as hazards $h_3$, $h_4$ and $h_5$ as shown in Fig. 6-A. The apparatus of the invention, however, triggers no flip-flop by the decoded output of the counter as the conventional apparatus in Fig. 1, whereby these hazards cause no malfunction and no conversion error as discussed below.

As seen from Fig. 6-B, the active level duration, when [1001000] is applied as the digital input value, increases surely to an extent of seven clock pulse period with respect to that in Fig. 6-A.

The duration, as shown in Fig. 6-D, increases surely to an extent of two clock pulse period with respect to Fig. 6-C when [1000010] is applied.

Similarly, one clock pulse period further increases when [1000001] is applied and the same period further increases when [1000000] is applied.

Upon applying [0111111] as digital input value, the output signal, as shown in Fig. 6-G, is affected by hazards $h_6$, $h_7$, $h_8$, $h_9$, $h_{10}$, and $h_{11}$ (not shown), and a pulse width of each hazard corresponds to a transfer delay time of each flip-flop to thereby become one clock pulse period from six hazards. Consequently, the active level duration increases by one clock pulse period with respect to Fig. 6-F.

As seen from Fig. 6-H, the active level duration, when [0111110] is applied for digital input value, increases further by one clock pulse period, further by one clock pulse period when [0111101] is applied, further by two clock pulse period when [0111011] is applied, further by four clock pulse period when [0110111] is applied, and further by eight clock pulse period when [0101111] is applied (see Figs. 6-I, -J, -K and -L).

It is seen from Figs. 6-M and -N that the active level duration also increases surely by one clock pulse period when the digital input value is changed to [0100000] from [0100001].

As seen from the above, the digital-to-analog conversion apparatus of the invention need not use, as particular countermeasures to hazards, a synchronous counter of a high speed type as conventional, so as to completely eliminate the conversion error caused by the transfer delay as well as malfunction. Accordingly, the apparatus of the invention, when using high speed gates as the same as the conventional one, can be used up to a high frequency only by a difference in the limit frequencies between the synchronous counter and a ripple counter, and when operated in the frequency about equal to the conventional apparatus, can actually reduce the number of gates and save the consumption power.

Now, Figs. 3 and 6 assume that each flip-flop makes a transfer delay by a 1/6 clock pulse period, but actually, it is often used in the frequency in closer proximity to the limit. Especially in $I^2L \cdot IC$ or the like suitable to this kind of system, a method is taken which reduces an injection current as the ripple counter becomes a higher order, thereby saving the consumption power.

In such method, the digital-to-analog apparatus of the invention also functions stably without occurrence of any conversion error.

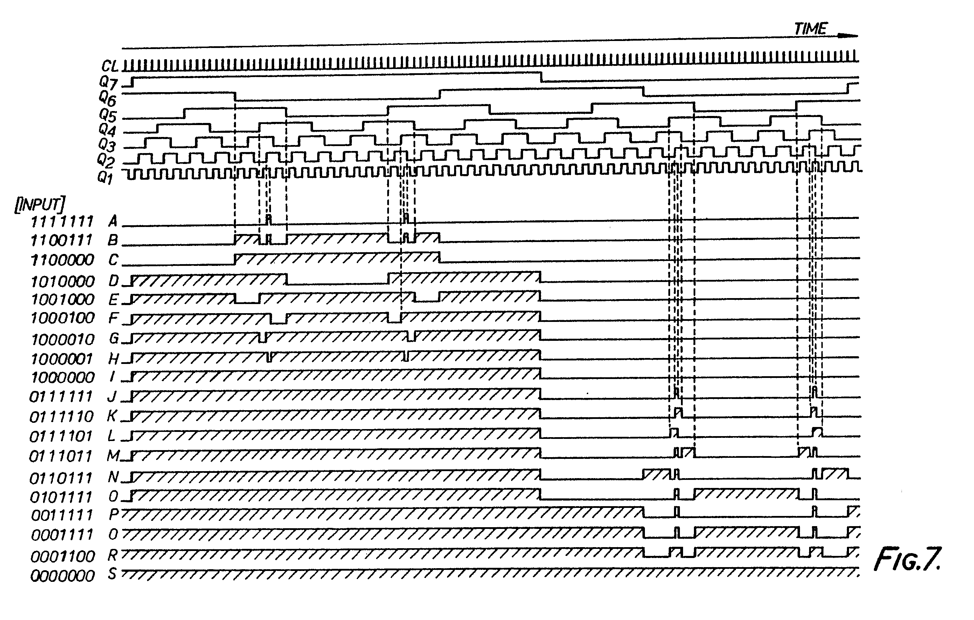

Fig. 7 shows the output waveforms for varying the digital input values, assuming that in each flip-flop a transfer delay having a time equel to 1/4 of the triggering signal period, from which it is seen that the active-level duration, also in the above case, changes accurately corresponding to a change of the digital input value. For example,

Fig. 7-I shows an output signal waveform when [1000000] is applied, in which the active-level duration is just 1/2 of the counting period of the 7-bit down-counter. When the digital input numeral decreases by 1 and becomes [0111111], hazards of 1/2 clock pulse period occur at two portions to increase the active level duration by one clock pulse period (see Fig. 7-J), and when the digital input value becomes [0111110], pulse widths of hazards apparently at two portions each become one clock pulse period, thereby further increasing the duration by one clock pulse period (see Fig. 7-K).

As seen from the above, the digital-to-analog conversion apparatus of the invention, even if a reference counter (7-bit down-counter in the Fig. 4 embodiment) and peripheral gates are considerably larger in a transfar delay, is simple in construction and performable in high accuracy without occurrence of a malfunction or a conversion error, as far as the reference counter keeps its function as the counter.

In addition, Fig. 4 shows the logic diagram of the embodiment of the invention designed thoroughly along the essence of the invention, in which the constitution of decoding gates or its decoding method, may alternatively be, for example, of a ROM type (an increased bit number will make it effective from the design of IC layout to adopt the ROM type), or the counter is not defined to the ripple or down counter, so that a synchronous counter may be used including the use of a dividing counter provided for other purposes.

The use of synchronous counter of course causes increase of a considerable number of gates, but the apparatus of the invention is still effective in reduction of the number of gates due to the fact that the EX-OR gate comprising the conventional digital comparator can be replaced by only one AND gate.

In Fig. 4, NAND gate 35, NOR gate 36, OR gate 37, and AND gate 38 are so constituted that the output of AND gate 34 which constitutes a logical OR gate in the negative logic, when MSB $D_7$ of the digital input value is at one level "1", becomes effective for one level "1" of MSB (Q7) at the counter (the level "1" in Fig. 4 alternatively may be "0"), and, when MSB of digital input value is at the other level "0", becomes effective for the other level "0" of MSB at the counter. When MSB at the digital input value is at one level "1", an output signal from logical AND of the outputs of the counter (in the Fig. 4 embodiment, the output of T flip-flop 7) and AND gate 34, is obtained, and when MSB at the digital input value is at the other level "0", an output signal by logical OR of the outputs of the counter and AND gate 34 is obtained. The reason for the above is that, throughly in consideration of the transient characteristic of the whole system, the constitution is designed so that no abrupt change occurs in the output signal waveform when the digital input value changes from [1000000] to [0111111]. Alternatively, the apparatus may be so constituted that the output of AND gate 34 is effective always when MSB at the counter is "1" or "0", which may be rather simple in circuitry.

In addition, in the Fig. 4 embodiment, it is applied the inverted output which appears on the sixth bit of the counter to the auxiliary gate, which is merely for technique on the circuitry composition, so that, even if the non-inverted output is applied to the auxiliary gate, this invention is not inferior in essence.

### Claim

1. A digital-to-analog conversion apparatus comprising: a binary counter (1—7) having a clock pulse input terminal (CL) connected to a clock pulse source, a decoding gate means (19—27) having a plurality of input terminals coupled to each of output bits of said binary counter and generating output signals of binary-weighted pulse widths respectively; a plurality of digital input terminals ($D_1$—$D_7$) for receiving a digital input value; a plurality of first logical gates (28—33) which are respectively connected at their respective first input terminals to output terminals of said decoding gate means and at their respective second input terminals to said digital input terminals; a second logical gate (34) coupled at its input terminals to output terminals of said first logical gates; and an output means (38) for generating an output signal, the number of changes and active-level duration of said output signal varying depending on said digital input value, characterized in that said output means comprise: a logical NAND gate (35) having first and second input terminals respectively coupled to the MSB (most significant bit) ($\overline{Q}_7$) of said binary counter and the MSB of said digital input terminals ($D_7$); a logical NOR gate (36) having first and second input terminals respectively coupled to the MSB of said binary counter and the MSB of said digital input terminals; a logical OR gate (37) having first and second input terminals respectively coupled to an output terminal of said logical NOR gate (36) and an output terminal of said second logical gate; and a logical AND gate (38) having first and second input terminals coupled to an output terminal of said logical NAND gate (35) and an output terminal of said logical OR gate.

### Patentanspruch

Digital-Analog-Umwandlungsgerät, enthaltend: einen Binärzähler (1—7) mit einem Taktimpulseingangsanschluß (CL), der mit einer Taktimpulsquelle verbunden ist, eine Dekodiertoreinrichtung (19—27) mit mehreren Eingangsanschlüssen, denen jeweils die Ausgangsbits des Binärzählers zugeführt sind und die Ausgangssignale jeweils binärgewichteter Impulsbreiten erzeugt; mehrere Digitaleingangsanschlüsse ($D_1$—$D_7$) zur Aufnahme eines digitalen Eingangswertes; eine Mehrzahl erster Logikschaltungen (28—33), die jeweils mit ihren ersten Eingangsanschlüssen mit den Ausgangsanschlüssen der Dekodiertoreinrichtung und mit ihren jeweiligen zweiten Eingangsanschlüssen mit den genannten Digitaleingangsanschlüssen verbunden sind; eine zweite Logikschaltung (34), die mit ihren Eingangsanschlüssen mit den Augangsanschlüssen der ersten Logikschaltungen verbunden ist; und eine Ausgangseinrichtung (38) zum Erzeugen eines Ausgangssignals, wobei die Anzahl der Wechsel und der Aktivpegeldauer des Ausgangssignals in Abhängigkeit von dem digitalen Eingangswert variiert, dadurch gekennzeichnet, daß die Ausgangseinrichtung enthält: eine logische NAND-Schaltung (35) mit ersten und zweiten Eingangsanschlüssen, die mit dem MSB (am meisten signifikanten Bit) ($\overline{Q}_7$) des Binärzählers bzw. mit dem MSB der digitalen Eingangsanschlüsse ($D_7$) verbunden sind; eine logische NOR-Schaltung (36) mit ersten und zweiten Eingangsanschlüssen, die mit dem MSB des Binärzählers bzw. mit dem MSB der digitalen Eingangsanschlüsse verbunden sind; eine logische ODER-Schaltung (37) mit ersten und zweiten Eingangsanschlüssen, die mit einem Ausgangsanschluß der logischen NOR-Schaltung (36) bzw. einem Ausgangsanschluß der zweiten Logikschaltung verbunden sind; und eine logische UND-Schaltung (38) mit ersten und zweiten Eingangsanschlüssen, die mit einem Ausgangsanschluß der logischen NAND-Schaltung (35) bzw. einem Ausgangsanschluß der logischen ODER-Schaltung verbunden sind.

### Revendication

Appareil de conversion numérique-analogique comportant: un compteur binaire (1—7) comprenant une borne d'entrée d'impulsions d'horloge CL connectée à une source d'impulsions d'horloge, un circuit à portes de décodage (19, 27) comprenant plusieurs bornes d'entrée connectées à chacun des bits de sortie dudit compteur binaire et produisant des signaux de sortie de durée d'impulsions avec une pondération binaire respectivement; plusieurs bornes d'entrée numériques ($D_1$, $D_7$) destinées à recevoir une valeur numérique d'entrée, plusieurs premières portes logiques (28, 33) qui sont connectées respectivement par leurs premières bornes d'entrée respectives à des bornes de sortie dudit circuit à portes de décodage et par leurs secondes bornes d'entrée respectives auxdites bornes d'entrée numériques; une seconde porte logique (34) connectée par ses bornes d'entrée à des bornes de sortie desdites premières portes logiques, et un dispositif de sortie (38) destiné à produire un signal de sortie, le nombre des changements et la durée de niveau actif dudit signal de sortie changeant en fonction de ladite valeur numérique d'entrée; caractérisé en ceu ledit dispositif de sortie comporte: une porte logique NON-ET 35 avec une première et une seconde borne d'entrée connectées respectivement au MSB (bit de plus grand poids), ($\overline{Q}_7$) dudit compteur binaire et au MSB desdites bornes d'entrée numériques ($D_7$); une porte logique NON-OU (36) avec une première et une seconde borne d'entrée connectées respectivement au MSB dudit compteur binaire et au MSB desdites bornes d'entrée numériques, une porte logique OU (37) avec une première et une seconde borne d'entrée connectées respectivement à une borne de sortie de ladite porte logique NON-OU (36) et à une borne de sortie de ladite seconde porte logique; et une porte logique ET (38) avec une première et une seconde borne d'entrée connectées à une borne de sortie de ladite porte logique NON-ET 35 à une borne de sortie de ladite porte logique OU.

**Fig. I.**
(PRIOR ART)

FIG.2.
(PRIOR ART)

0 058 064

Fig. 3.
(PRIOR ART)

FIG.4.

0 058 064

FIG.5.

0 058 064

FIG. 6.

TIME

CL
Q7
Q6
Q5
Q4
Q3
Q2
Q1

[INPUT]
1111111  A
1100111  B
1100000  C
1010000  D
1001000  E
1000100  F
1000010  G
1000001  H
1000000  I
0111111  J
0111110  K
0111101  L
0111011  M
0110111  N
0101111  O
0011111  P
0001111  O
0001100  R
0000000  S

*Fig.7.*

0 058 064